# EUROPÄISCHE PATENTANMELDUNG

(11) **EP 1 396 469 A2**
(43) Veröffentlichungstag der Anmeldung: **10.03.2004**
(21) Anmeldenummer: 03010777.5
(22) Anmeldetag: 14.05.2003
(51) Int. Cl.: B81B 3/00

(54) **Halbleiterbauelement mit Bereichen unterschiedlicher Porenstruktur und Herstellungsverfahren**

(30) Priorität: 05.09.2002 DE 10241066
(71) Anmelder: ROBERT BOSCH GMBH, 70442 Stuttgart (DE)
(72) Erfinder: Brenzel, Hubert, 72124 Pliezhausen (DE); Artmann, Hans, 71106 Magstadt (DE); Schaefer, Frank, 72070 Tübingen (DE)

(57) **Zusammenfassung**

Es wird ein Halbleiterbauelement und ein Verfahren vorgeschlagen, wobei ein Halbleitersubstrat (101) vorgesehen ist, wobei ein erster Teilbereich (122) und ein zweiter Teilbereich (121, 125, 126) vorgesehen ist, wobei sich die Porenstruktur des ersten Teilbereichs von der Porenstruktur des zweiten Teilbereichs unterscheidet.

## Beschreibung

### Stand der Technik

Die Erfindung geht aus von einem Halbleiter-Bauelement und einem Verfahren nach der Gattung der nebengeordneten Ansprüche. Aus der DE 10032579 A1 ist bereits ein Verfahren zur Herstellung eines Halbleiterbauelements und ein Halbleiterbauelement bekannt, bei dem ein Hohlraum bzw. eine Kaverne in bzw. auf einem Halbleitersubstrat erzeugt wird und dieses zur Drucksensierung herangezogen wird. Hierbei ist gemäß dem Stand der Technik eine Schicht des Halbleiterbauelementes aus porösem Silizium vorgesehen. Es wird dabei ein Drucksensor in Oberflächenmikromechanik mittels der Umlagerung von porösem Silizium erzeugt. Die Umlagerung führt zu der Bildung einer Kaverne bzw. eines Hohlraums unterhalb einer Membran aus Silizium.

### Vorteile der Erfindung

Das erfindungsgemäße Halbleiterbauelement und das erfindungsgemäße Verfahren mit den Merkmalen der nebengeordneten Ansprüche haben dem gegenüber den Vorteil, dass ein vorzeitiges Schließen der Oberfläche und damit ein vorzeitiges Schließen des Hohlraumes bzw. der Kaverne vermieden wird. Die Umlagerung des porösen Siliziums zur Bildung der Kaverne bzw. des Hohlraumes ist in mehrere Prozessschritte unterteilt. Nach der Erzeugung der porösen Siliziumstruktur muss daher in einem ersten Prozessschritt zur Umlagerung das gebildete native Siliziumoxid, welches sich durch Lagerung an Luft bildet, bei Temperaturen zwischen 900 und 1100°C in einer H₂-Atmosphäre gelöst (reduziert) werden. In einem zweiten Prozessschritt zur Umlagerung wird anschließend die Oberfläche des porösen Siliziums bei 900°C bis 1200°C in H₂-Atmosphäre geschlossen. In einem dritten Prozessschritt zur Umlagerung wird durch epitaktisches Aufwachsen von Silizium eine Membran gebildet, wobei sich auch bei dem Aufwachsen des Siliziums noch das poröse Silizium teilweise umlagert und damit zur Bildung der Kaverne beiträgt. Das Lösen des Siliziumoxides im ersten Prozessschritt ist erforderlich, da sonst die anschließende Umlagerung nicht oder nur sehr schlecht stattfinden kann. Das Lösen des Siliziumoxides wird durch die reduzierende H₂-Atmosphäre beim ersten Prozessschritt gewährleistet. Gleichzeitig schließt sich bei diesem Temperschritt die Oberfläche, so dass es zum vorzeitigen Schließen der Oberfläche kommen kann und so noch Restoxid in der porösen Siliziumschicht zurück bleibt. In dieser Situation wird ein vollständiges Umlagern in der porösen Siliziumschicht und somit die Bildung der Kaverne verhindert bzw. erschwert. Das erfindungsgemäße Halbleiterbauelement bzw. das erfindungsgemäße Verfahren vermindern dieses vorzeitige Schließen der porösen Siliziumschicht, und gewährleistet so eine sichere und vollständige Bildung der Kaverne. Das erfindungsgemäße Mittel zur Herbeiführung dieses Effektes einer Vermeidung der vorzeitigen Schließung der Kaverne ist, dass sog. Lüftungslöcher in der porösen Siliziumschicht eingeführt werden. Hierdurch wird ein frühzeitiges Schließen der Oberfläche verhindert und so eine vollständige Oxidlösung mit anschließender Umlagerung gewährleistet. Diese Lüftungslöcher werden erfindungsgemäß dadurch erzeugt, dass eine gezielte Unterätzung in bestimmten Membranbereichen vorgesehen ist, wodurch eine andere Porenstruktur in diesen Membranbereichen als in dem restlichen Membranbereich erzeugt wird. Diese andere Porenstruktur schließt sich erfindungsgemäß deutlich später als die Porenstruktur des restlichen Membranbereichs.

Durch die in den Unteransprüchen aufgeführten Maßnahmen sind vorteilhafte Weiterbildungen und Verbesserungen des in den nebengeordneten Ansprüchen angegebenen Halbleiterbauelementes bzw. des Verfahrens möglich. Besonders vorteilhaft ist, dass die vormalige Porenstruktur im ersten Teilbereich im Wesentlichen senkrecht zur Hauptsubstratebene orientiert ist und dass die vormalige Porenstruktur im zweiten Teilbereich im Wesentlichen parallel zur Hauptsubstratebene orientiert ist. Diese lateralen Poren, welche waagrecht, d.h. parallel zur Hauptsubstratebene verlaufen, wenn die Hauptsubstratebene des Substrats waagrecht liegt, schließen sich wesentlich später als Poren, welche senkrecht zur Oberfläche, das heißt senkrecht zur Hauptsubstratebene, vorgesehen sind. Die Bereiche der Membranfläche, welche laterale Poren aufweisen, können somit als die erfindungsgemäßen Lüftungslöcher zum Gasaustausch in den letzten Stadien der Lösung des Siliziumoxides verwendet werden. Weiterhin ist von Vorteil, dass die vormalige Porenstruktur im zweiten Teilbereich mesoporös vorgesehen ist oder dass die vormalige Porenstruktur im zweiten Teilbereich nanoporös vorgesehen ist oder dass die Porenstruktur im zweiten Teilbereich höher porös als im ersten Teilbereich vorgesehen ist. Hierdurch sind in einfacher Weise unterschiedliche Möglichkeiten zur Bildung der erfindungsgemäßen Lüftungslöcher möglich. Im Bereich der Lüftungslöcher ist die Kristallstruktur der Epitaxieschicht mit mehr Fehlern behaftet, was besonders charakteristisch für die höhere Porösität bzw. die nano- oder mesoporöse Porenstruktur bzw. für die Verlaufsrichtung der Poren parallel zur Oberfläche ist. Weiterhin ist von Vorteil, dass das Halbleitersubstrat aus Siliziummaterial besteht. Hierdurch ist es möglich, durch die gezielte Einführung von Poren die erfindungsgemäße Kaverne bzw. den erfindungsgemäßen Hohlraum in einfacher Weise kontrolliert zu erzeugen. Weiterhin ist von Vorteil, dass oberhalb der porösen Schicht eine epitaktische Schicht vorgesehen ist. Hierdurch ist es möglich, verschiedene Arten von piezoempfindlichen Messelementen in die epitaktische Schicht aufzunehmen und damit beispielsweise das erfindungsgemäße Halbleiterbauelement als Drucksensor zu verwenden.

### Zeichnungen

Ausführungsbeispiele der Erfindung sind in der Zeichnung dargestellt und in der nachfolgenden Beschreibung näher erläutert.

Es zeigen:
Figur 1 eine Vorstufe eines herkömmlichen Drucksensors gemäß dem Stand der Technik.
Figur 2 eine weitere Vorstufe des bekannten Drucksensors,
Figur 3 einen bekannten Drucksensor gemäß dem Stand der Technik,
Figur 4 verschiedene Prozessstadien des erfindungsgemäßen Halbleiterbauelementes,
Figur 5 eine erste Ausführungsform zur Herstellung der erfindungsgemäßen Lüftungslöcher,
Figur 6 eine zweite Ausführungsform zur Herstellung der erfindungsgemäßen Lüftungslöcher,
Figur 7 eine erste Variante der Anordnung der erfindungsgemäßen Lüftungslöcher und
Figur 8 eine zweite Variante der Anordnung der erfindungsgemäßen Lüftungslöcher.

### Beschreibung der Ausführungsbeispiele

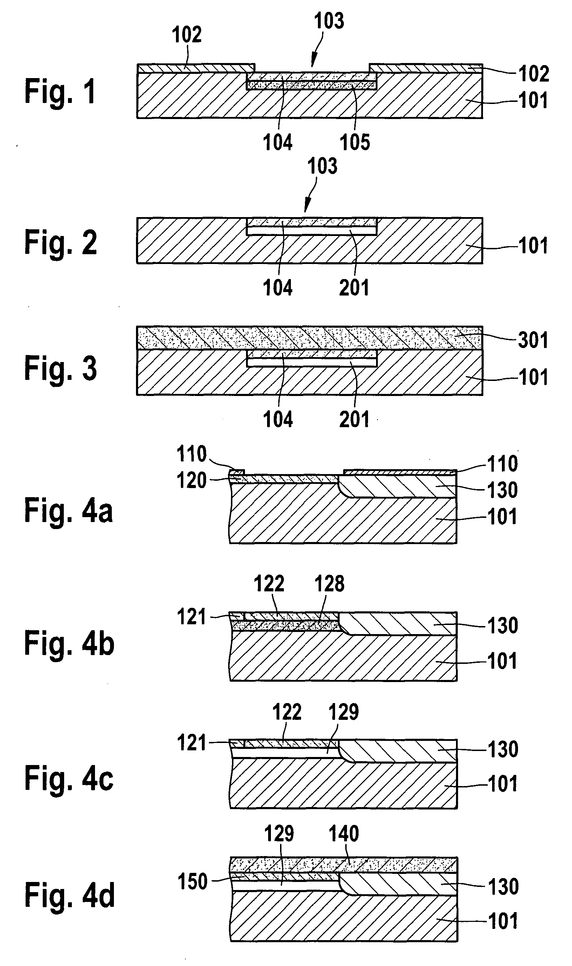

Figur 1 zeigt eine Vorstufe eines herkömmlichen Drucksensors. Auf der Oberseite eines Siliziumsubstrats 101 wird eine Maskenschicht 102 erzeugt, wobei ein nicht durch die Maskenschicht 102 abgedeckter Bereich 103 entsteht. Bei der Maskenschicht kann es sich beispielsweise um eine Nitridschicht, eine N-dotierte Schicht (bei P-dotiertem Siliziumsubstrat) oder eine sonstige geeignete Schicht handeln, die von dem nachfolgend verwendeten Ätzmedium weitgehend nicht angegriffen wird. Die Oberseite des Siliziumsubstrats 101 wird elektrochemisch unter Verwendung eines geeigneten Ätzmediums derart geätzt, dass das Ätzmedium unmittelbar unter dem nicht abgedeckten Bereich 103 kleine Öffnungen bzw. Poren in dem Siliziumsubstrat 101 erzeugt. Es entsteht eine Siliziumschicht 104 mit geringer Porosität. Durch diese kleinen Öffnungen bzw. Poren der Siliziumschicht 104 gelangt das Ätzmedium in tiefergelegene Bereiche des Siliziumsubstrats 101 und bildet ebenfalls Poren mit dem dort befindlichen Silizium. Hierbei entsteht eine poröse Siliziumschicht 105 unterhalb der porösen Siliziumschicht 104. Bei dem Ätzmedium zum elektrochemischen Ätzen, wie insbesondere Nassätzen, handelt es sich bevorzugt um Flusssäure (HF) oder um ein Ätzmedium, das u.a. Flusssäure (HF) enthält. Erfindungsgemäß wird bevorzugt ein elektrisches Feld zwischen der Oberseite und der Unterseite des Siliziumsubstrats 101 erzeugt, wobei über die eingestellte elektrische Feldstärke bzw. die eingestellte elektrische Stromdichte die Ausdehnungsgeschwindigkeit der Poren bzw. Öffnungen bzw. Hohlräume beeinflusst wird. Bei einem bevorzugten elektrochemischen Ätzverfahren gemäß der Verfahren werden zu ätzende Vorstufen des Drucksensors in ein wannenförmiges Gefäß gegeben, das mit dem Ätzmedium gefüllt ist und es wird eine elektrische Spannung derart an gegenüberliegenden Enden des Ätzmediums angelegt, dass das elektrische Feld entsteht. Um dafür zu sorgen, dass die oberen poröse Siliziumschicht 104 im Bereich unmittelbar unter dem von der Maskenschicht 102 ausgesparten Bereich 103 entsteht, wird nach dem Aufbringen des Ätzmediums auf den nicht abgedeckten Bereich 103 in einem ersten Schritt eine nicht notwendigerweise konstante elektrische Stromdichte eingestellt. Sie ist vorzugsweise derart gewählt, dass unmittelbar unter dem nicht abgedeckten Bereich 103 Öffnungen bzw. Poren im Siliziumsubstrat 101 entstehen. Ein weiteres wichtiges Kriterium für die in dem ersten Schritt eingestellte, nicht notwendigerweise konstante elektrische Stromdichte darin, eine solche elektrische Stromdichte einzustellen, bei der geeignete Öffnungen bzw. Poren im Siliziumsubstrat 101 unmittelbar unter dem nicht abgedeckten Bereich 103 entstehen. Geeignet sind insbesondere solche Öffnungen bzw. Poren, die es nachfolgend gestatten, auf der während des Ätzvorgangs gebildeten porösen Siliziumschicht 104 eine weitgehend monokristalline Siliziumschicht abzuscheiden, die die eigentliche Sensormembran bildet. Daher dürfen die Öffnungen bzw. Poren nur eine adäquate Größe bzw. einen adäquaten Durchmesser aufweisen. Bevorzugte Öffnungen bzw. Poren haben beispielsweise einen Durchmesser von ca. 10-100 nm, vorzugsweise ca. 10-30 nm. Es versteht sich, dass dies lediglich ein Beispiel für geeignete Öffnungen bzw. Poren ist. Nachdem das Ätzmedium die poröse Siliziumschicht 104 durchdrungen hat, wird im weiteren Verlauf bevorzugt die Stromdichte im Vergleich zur Stromdichte zur Bildung der oberflächlicheren porösen Siliziumschicht 104 erhöht, wodurch die Poren vergrößert bzw. die Hohlraumausdehnungsgeschwindigkeit gesteigert wird und größere Poren in der tiefergelegenen Siliziumschicht 105 im Vergleich zu den Poren in der oberflächlicheren porösen Siliziumschicht 104 entstehen. Das von dem Ätzmedium zersetzte Silizium wird während des Ätzvorgangs und/oder nachfolgend über die Öffnungen bzw. Poren in der porösen Siliziumschicht 104 entfernt und "frisches" Ätzmedium herangeführt.
Bei dem in Figur 1 dargestellten Verfahren zur Herstellung einer Vorstufe eines erfindungsgemäßen Halbleiterbauelementes wird der Ätzvorgang zur Herstellung des in Figur 2 dargestellten, späteren Hohlraums 201 durch die Wahl geeigneter Prozessparameter und/oder eines oder mehrerer geeigneter Ätzmedien derart eingestellt, dass die Porosität der Siliziumschicht 105, die den späteren Hohlraum 201 bildet, ausreichend groß ist. Unter "ausreichend" wird bevorzugt eine Porosität verstanden, die größer als 60 % und kleiner als 100 % ist. Nachfolgend wird bei dem Drucksensor bzw. Halbleiterbauelement gemäß dem Stand der Technik eine Temperung vorgenommen. Die Temperung erfolgt bevorzugt unter einer Wasserstoffatmosphäre, unter einer Stickstoffatmosphäre oder unter einer Edelgasatmosphäre und/oder bei einer Temperatur von über ca. 900°C. Aufgrund der hohen Porosität der Siliziumschicht 105 (vgl. Figur 1) ordnen sich bei der Temperung die Poren der tiefer gelegenen porösen Siliziumschicht 105 derart um, dass unterhalb der gering porösen Siliziumschicht 104 eine einzelne große Pore entsteht, mithin also der in Figur 2 dargestellte Hohlraum bzw. die dargestellte Kaverne 201. Die Poren auf der Oberseite der gering porösen Siliziumschicht 104 werden bei der Temperung bzw. dem Hochtemperaturschritt weitgehend verschlossen, so dass auch diese die eigentliche Sensormembran, welche in Figur 3 mit dem Bezugszeichen 301 bezeichnet ist, als eine weitgehend monokristalline Siliziumschicht abgeschieden werden kann. In Figur 3 ist das herkömmliche Halbleiterbauelement mit einer abgeschlossenen Kaverne 201 dargestellt.

Bei der Herstellung der abgeschlossenen Kaverne ergeben sich bei dem Prozessschritt des Schließens der oberen porösen Schicht, welche in den Figuren 1 bis 3 mit dem Bezugszeichen 104 bezeichnet ist, das Problem, dass sich Siliziumoxid, welches sich nach der Bildung der porösen Schichten bei Lagerung an Luft bildet (natives Oxid), vor einem vollständigen Verschließen der Kaverne bzw. des Hohlraumes 201 noch nicht vollständig entfernt wurde. Dies soll erfindungsgemäß vermieden werden.

Figur 4 stellt verschiedene Herstellungsstadien des erfindungsgemäßen Halbleiterbauelementes dar. In der Figur 4a ist wiederum ein Substrat 101 dargestellt, welches die Grundlage des erfindungsgemäßen Halbleiterbauelementes bildet. Auf dem Substrat 101 wird eine Schicht gebildet, die vergleichsweise stark positiv (Dotierstoffkonzentration > 5.10¹⁶ l/cm³) dotiert ist und in Figur 4a mit dem Bezugszeichen 120 versehen ist. Unterhalb dieser Schicht 120 bildet sich später die Kaverne des erfindungsgemäßen Halbleiterbauelements und im Bereich dieser Schicht 120 bildet sich die Decke der Kaverne, die im folgenden auch als Deckschicht bezeichnet wird. Weiterhin ist ein Substratbereich mit dem Bezugszeichen 130 versehen, welcher negativ dotiert ist und in dem später keine Poren durch das Ätzverfahren zur Herstellung von porösem Silizium erzeugt werden können. Der mit dem Bezugszeichen 130 bezeichnete Substratbereich dient später als Rand bzw. Rahmen, welcher den Membranbereich, in dem sich die Kaverne und ihre Deckschicht befindet, umgibt. Erfindungsgemäß ist es vorgesehen, eine Abdeckung 110 im Membranbereich vorzusehen, welche ebenso wie die im Zusammenhang mit Figur 1 beschriebene Schicht 102 gemäß dem Stand der Technik verhindert, dass der darunterliegende Bereich porös wird. Es wird nun eine Ätzung des derart präparierten Substrats 101 vorgenommen, deren Resultat in Figur 4b dargestellt ist. Die Ätzung umfasst ebenfalls wie im Zusammenhang mit dem herkömmlichen Halbleiterbauelement beschriebenen Verfahren ein erstes Stadium, in welchem zum einen eine Deckschicht gebildet wird, welche eine vergleichsweise geringe Porosität aufweist und in welchem zum anderen unter der Deckschicht, d.h. tiefer gelegen, eine zweite Schicht gebildet wird, welche eine höhere Porosität aufweist. Anschließend wird durch einen weiteren Verfahrensschritt eine Umlagerung des Halbleitermaterials bewirkt, wobei sich in dem höher porösen Bereich eine Kaverne bildet, indem Siliziumteilchen dort umgeordnet und teilweise auch in den Bereich der Deckschicht eingelagert werden. Durch diese Umlagerung entsteht die Kaverne, welche in den Figuren 4c und 4d mit dem Bezugszeichen 129 versehen ist und darüber liegend eine Deckschicht, welche auf die gering poröse Substratschicht zurück geht. Nach der Umlagerung weist die Deckschicht in der Regel eine geringer ausgeprägte Porenstruktur auf als während ihres Zustandes nach dem Porösizieren und vor der Umlagerung. Jedoch ist die vormalige Porenstruktur auch nach der Umlagerung noch erkennbar. Die in Figur 4a mit dem Bezugszeichen 120 versehene gering poröse Substratschicht teilt sich bei dem Ätzvorgang wegen dem Nichtvorhandensein einer Abdeckung 110 in einem ersten Teilbereich der Deckschicht und wegen dem Vorhandensein der Abdeckung 110 in einem zweiten Teilbereich der Deckschicht auf. Der erste Teilbereich 122 ist beim Ätzvorgang nicht von der Abdeckung 110 abgedeckt und der zweite Teilbereich 121 ist beim Ätzvorgang von der Abdeckung 110 abgedeckt. Beide Teilbereiche zusammen bilden insbesondere nach der Umlagerung die Deckschicht 150, welche in Figur 4d ohne Differenzierung ihres ersten und zweiten Teilbereichs dargestellt ist. Durch die Abdeckung 110 oberhalb des zweiten Teilbereichs 121 der Deckschicht 150 während des Ätzvorgangs verlaufen die Poren im Wesentlichen lateral, d.h. parallel zur Oberfläche bzw. parallel zur Hauptsubstratebene des Substrats 101. Im ersten Teilbereich 122 der Deckschicht 150 verlaufen die Poren im Wesentlichen senkrecht zur Hauptsubstratebene des Substrats 101. Unterhalb der Deckschicht 150 befindet sich die Schicht mit einem höheren Anteil an Porosität (zwischen 60% Porosität und 100% Porosität) vor der Umlagerung bzw. die Kaverne nach der Umlagerung. Diese Schicht ist in Figur 4b mit dem Bezugszeichen 128 (vor der Umlagerung) versehen und in der Figur 4c mit dem Bezugszeichen 129 versehen, welches das Resultat der Umlagerung des Siliziummaterials zur Bildung der Kaverne 129 darstellen soll. Die umgelagerten Teilbereiche 121 und 122 der oberflächlich angeordneten, porösen Schicht werden in Figur 4d zusammenfassend als die Deckschicht 150 bzw. Abdeckschicht 150 dargestellt. Oberhalb der Abdeckschicht 150 ist die eigentliche Membranschicht 140 dargestellt, welche erfindungsgemäß insbesondere aus epitaktisch aufgewachsenem, einkristallinem Silizium vorgesehen ist. In der Membranschicht 140 wird erfindungsgemäß ein oder mehrere Messelemente zur Detektion der Verformung der Membranschicht 140 eingebracht, beispielsweise über Dehn-Widerstände bzw. über piezoresistive Widerstände. Die Membranschicht 140 bildet damit die eigentliche Sensormembran.

Die in Figur 4a dargestellte oberflächliche Schicht 120, welche vergleichsweise hoch dotiert ist, weist nach dem Ätzvorgang im Bereich, wo keine Abdeckung 110 vorgesehen ist, eine Porenstruktur auf, die mesoporös und senkrecht zur Oberfläche orientiert ist. Diese vergleichsweise hochdotierte Schicht 120 weist einen elektrischen Widerstand von ungefähr 0,1 Ωcm auf und eine Dicke von ca. 1 µm. Diese senkrecht angeordneten, mesoporösen Poren schließen sich bei der erfindungsgemäßen Umlagerung des Siliziummaterials vergleichsweise schnell. Da die Bildung von porösem Silizium ein isotroper Ätzprozess ist, wird die als Maske verwendete Abdeckung 110, die beispielsweise aus Siliziumnitrid besteht, lateral unterätzt. Hierdurch entstehen die im zweiten Teilbereich 121 im Wesentlichen parallel zur Oberfläche der Abdeckschicht verlaufenden Poren. Die Porenstruktur im zweiten Teilbereich 121 der Deckschicht 150 kann damit als lateral bezeichnet werden. Diese lateralen Poren schließen sich bei der Temperaturbehandlung wesentlich später und können somit als erfindungsgemäße Öffnungen zum Gasaustausch bzw. als erfindungsgemäße Lüftungslöcher verwendet werden.

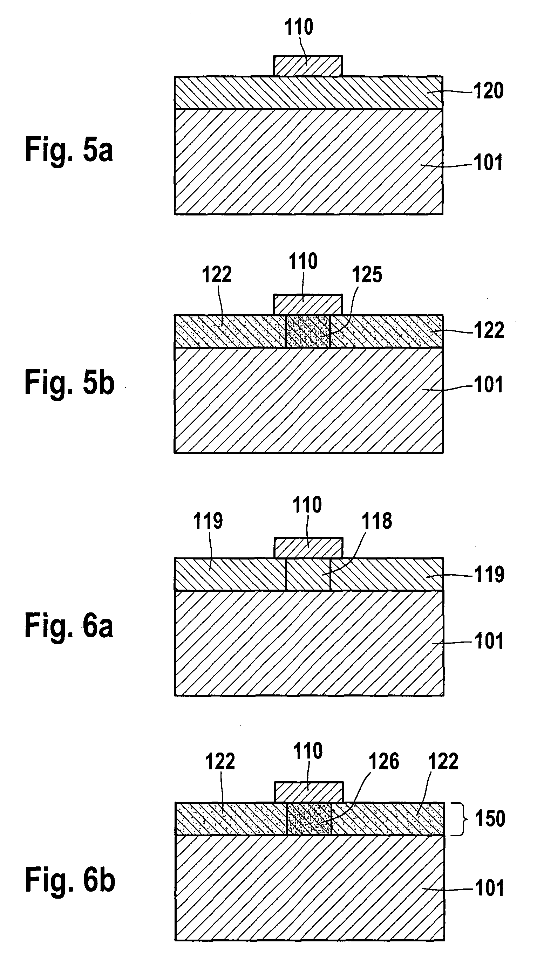

In Figur 5 und 6 werden zwei unterschiedliche Ausführungsformen zur Herstellung der erfindungsgemäßen lateralen Porenstruktur bzw. zur Herstellung der erfindungsgemäßen Lüftungslöcher dargestellt.

In Figur 5 ist auf dem Siliziumsubstrat 101 wiederum die oberflächliche Dotierung vorgesehen, welche zur Schicht 120 auf dem Siliziumsubstrat 101 führt und welche relativ stark positiv dotiert vorgesehen ist. Im ersten Teilbereich dieser Schicht 120 ist keine Abdeckung 110 vorgesehen und in einem zweiten Teilbereich dieser Schicht ist eine Abdeckung 110 vorgesehen. Dies sind die in Figur 5a dargestellten Verhältnisse vor dem Ätzvorgang. In Figur 5b sind die Verhältnisse nach dem ersten Schritt des Ätzvorgangs dargestellt, hierbei ist im ersten Teilbereich 122 der oberflächlich dotierten Schicht 120 poröses Silizium entstanden, welches eine Porenstruktur mit senkrecht verlaufenden Poren aufweist. Im zweiten Teilbereich, das heißt unter der Abdeckung 110, ist ein mit dem Bezugszeichen 125 bezeichneter Bereich entstanden, welcher eine laterale Porenstruktur aufweist. Dieser Bereich weist eine Porenstruktur mit mesoporösem Silizium auf. Die Größe der Abdeckung 110 richtet sich nach der Unterätzung. Beispielhaft beträgt die Unterätzung des Bereichs 110 etwa 15 µm und die Größe der Abdeckung 110 in Richtung dieser Unterätzung wird mit etwa 10-20 µm ausgewählt. Die Unterätzung ist in Figur 5b dadurch sichtbar gemacht, dass der zweite Teilbereich 125 schmäler ist als die Abdeckung 110.

In Figur 6 ist eine zweite Ausführungsform zur Realisierung der erfindungsgemäßen Lüftungslöcher dargestellt, wo die oberflächlich dotierte Schicht 120 jedoch einen höher dotierten Bereich 119 (Dotierstoffkonzentration > 5-10¹⁶ l/cm3) und einen geringer dotierten Bereich 118 umfasst (Substratdotierung, ca. 5·10¹⁵ 1/cm³).Der weniger stark dotierte Bereich 118 befindet sich unterhalb der Abdeckung 110 bzw. des Abdeckbereichs 110. Erfindungsgemäß ist es insbesondere vorgesehen, dass die Dotierung des geringer dotierten Bereichs 118 der Dotierung des Substrats 101 entspricht und dass zur Bildung der höher dotierten Bereiche 119 lediglich strukturiert die höhere Dotierung eingebracht wird. Wiederum ist in Figur 6a die Situation vor dem Ätzvorgang dargestellt. In Figur 6b ist die Situation nach dem ersten Schritt des ersten Ätzvorgangs dargestellt, das heißt, im nicht abgedeckten Bereich 122 der Deckschicht 150 befinden sich im Wesentlichen senkrecht verlaufende Poren und im zweiten Teilbereich der Deckschicht 150, welcher im Wesentlichen dem geringer dotierten Bereich 118 von vor dem Ätzvorgang entspricht, ist ein Bereich 126 entstanden, der im Wesentlichen eine Porenstruktur mit lateralen Poren aufweist. Jedoch entsteht hier im Bereich 126, das heißt im zweiten Teilbereich der Deckschicht 150, wegen der geringeren Dotierung in diesem Bereich kein mesoporöses Silizium mit geringer Porosität, sondern nanoporöses Silizium mit hoher Porosität, das sich jetzt ebenfalls wieder später als der restliche Membranbereich, d.h. der restliche Bereich der Deckschicht 150, schließt, wenn zur Lösung des Siliziumoxides ein Temperschritt durchgeführt wird. Die Größe der Abdeckung 110 richtet sich auch hier wieder nach der Größenordnung der Unterätzung. Beispielhaft ist die Ausdehnung des Abdeckbereichs 110 bei einer Unterätzung von ca. 6 µm in der Größenordnung von 5-10 µm vorgesehen.
In einer alternativen Ausführungsform kann es erfindungsgemäß vorteilhaft vorgesehen sein, dass die in Figur 6 dargestellte Überlappung des Abdeckbereichs 110 über den geringer dotierten Teilbereich 118 hinaus etwa gleichgroß vorgesehen ist wie die Dicke bzw. die Tiefe des höher dotierten Teilbereichs 119. Die Breite des Abdeckbereichs ist in diesem Fall deutlich größer als die doppelte Größe der Überlappung vorgesehen. In dieser Situation berühren sich die Ätzfronten der geringeren Porosität während des ersten Ätzschrittes unterhalb der Abdeckung 110 nicht. Beim zweiten Ätzschritt wird dann der unter der Abdeckung 110 liegende Teilbereich 118 hochporös geätzt, wodurch diese Bereiche dann die Funktion der Lüftungslöcher während der Temperung übernehmen.
In einer weiteren Ausführungsform kann in Fall von Figur 6 auf die Abdeckung 110 verzichtet werden. Hier entstehen dann nur senkrechte Porenstrukturen in den Teilbereichen 118 und 119. Durch die unterschiedlichen Dotierungen der Bereiche 118 und 119 entsteht im Bereich 118 nanoporöses Silizium mit einer höheren Porosität, welches sich bei den folgenden Temperschritten später als die umliegenden mesoporösen Bereiche 119 verschließt. So wird auch in diesem Fall das Lösen von nativem Oxid begünstigt. Die Größenordnung der Lüftungslöcher richtet sich nach der Dicke der Epitaxieschicht, da diese die Löcher zuverlässig verschließen muss. Der Lochdurchmesser muss daher kleiner sein als die Epitaxiedicke.

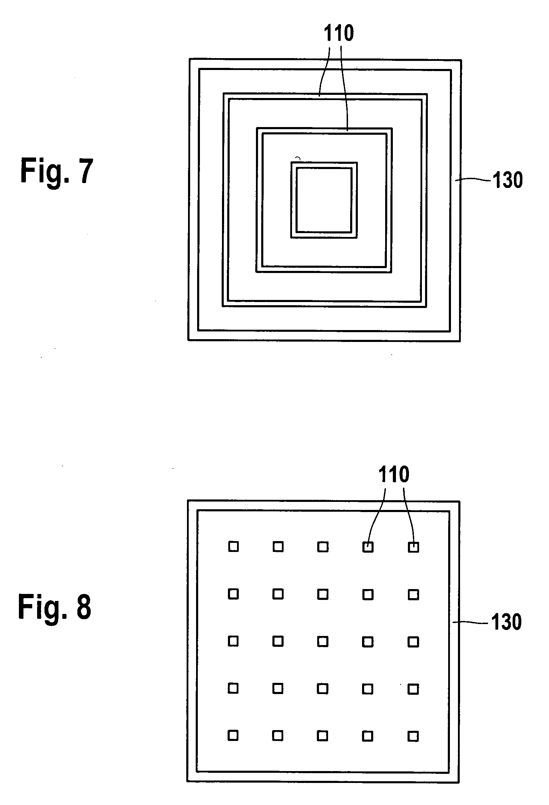

In Figur 7 ist eine erste Variante zur Verteilung bzw. zur Anordnung der Abdeckbereiche 110 auf der späteren Deckschicht 150 dargestellt. Dargestellt ist in Figur 7 und 8 eine Draufsicht auf den erfindungsgemäß relevanten Teil des Halbleiterbauelements. Der bereits bei Figur 4 beschriebene Bereich 130, welcher beispielsweise negativ dotiert ist und deshalb von dem porösizierenden Ätzvorgang nicht angegriffen wird, bildet den Rahmen, innerhalb dessen die Deckschicht 150 und die Kaverne 129 vorgesehen ist. Deckschicht 150 und Kaverne 129sind jedoch in Figur 7 und 8 nicht explizit angegeben. Die Verteilung der Abdeckung 110 ist in Figur 7 innerhalb des Membranbereichs, d.h. in dem vom des Bereich 130 des Substrats umschlossenen Bereich in Form von rechteckigen bzw. quadratischen Linien vorgesehen, so dass ein genügender Abstand vom Rand des Membranbereichs bzw. vom Rand der Kaverne gewährleistet ist. Die allgemeine Lage der Lüftungslöcher und damit der Abdeckung 110 sollte nicht im Bereich der in Figur 7 und 8 nicht dargestellten Messelemente liegen, die sich auf oder in der Membranschicht 140 befinden. Die Messanordnungen bzw. Messelemente in der Membranschicht 140 sind insbesondere als Piezowiderstände vorgesehen und diese befinden sich bevorzugt am Übergangsbereich am Rand der Kaverne 129. Da die Epitaxiequalität im Bereich der Lüftungslöcher bzw. der Abdeckung 110 nicht sehr gut bzw. schlechter als im übrigen Membranbereich ist, sollten die Zonen der Abdeckung 110 oder auch Abdeckzonen 110 nicht im Bereich des Randes der Kaverne 129 zu liegen kommen. Der Abstand der Abdeckzonen 110 zum Rand der Kaverne 129 sollte so bemessen sein, dass in der zur Verfügung stehenden Zeit während der Reinigung des Materials vom Siliziumoxid die H₂-Atmosphäre Zutritt zu allen Bereichen hat, die noch zu entfernendes Siliziumoxid aufweisen. Wenn alles Siliziumoxid entfernt ist, kann eine vollständige Umlagerung zur Bildung der Kaverne und der Deckschicht entstehen.

In Figur 8 sind die Abdeckbereiche 110 als Punkte bzw. als kleine Quadrate vorgesehen. Sowohl in Figur 7 als auch in Figur 8 sind die relevanten Abmessungen der abgedeckten Bereiche 110 bzw. in Figur 7 die Breite der abgedeckten Bereiche 110 wie vorhin im Zusammenhang mit den Ausmaßen der Abdeckung 110 beschrieben vorgesehen.

Die Anordnung der auch als Lüftungslöcher bzw. Lüftungslinien bzw. Lüftungsbereiche bzeichneten Lüftungslöcher 110 auf der Membran richtet sich optimalerweise nach der Spannungsverteilung in der Membran, so dass keine Spannungsmaxima an einzelnen Lüftungslöchern auftreten. Ebenso ist es in Figur 7 vorteilhaft, dass die Linien keine Ecken aufweisen, sondern abgerundet sind, bzw. Isolinien gleicher Spannung in der Membran folgen.

## Patentansprüche

1. Halbleiterbauelement, insbesondere ein Drucksensor, mit einem Halbleitersubstrat (101) und einem Hohlraum (129), wobei oberhalb des Hohlraums (129) eine aus porösem Siliziummaterial hervorgegangene Deckschicht 150 vorgesehen ist, **dadurch gekennzeichnet, dass** die Deckschicht (150) einen ersten Teilbereich (122) und einen zweiten Teilbereich (121, 125, 126) aufweist, wobei sich die vormalige Porenstruktur des ersten Teilbereichs (122) von der vormaligen Porenstruktur des zweiten Teilbereichs (121, 125, 126) unterscheidet.

2. Halbleiterbauelement nach Anspruch 1, **dadurch gekennzeichnet, dass** die vormalige Porenstruktur im ersten Teilbereich (122) im Wesentlichen senkrecht zur Hauptsubstratebene orientiert ist und dass die vormalige Porenstruktur im zweiten Teilbereich (121, 125, 126) im Wesentlichen parallel zur Hauptsubstratebene orientiert ist

3. Halbleiterbauelement nach einem der vorhergehenden Ansprüche, **dadurch gekennzeichnet, dass** die vormalige Porenstruktur im zweiten Teilbereich (121, 125, 126) mesoporös vorgesehen ist oder dass die vormalige Porenstruktur im zweiten Teilbereich (121, 125, 126) nanoporös vorgesehen ist oder dass die Porenstruktur im zweiten Teilbereich (121, 125, 126) höher porös als im ersten Teilbereich (122) vorgesehen ist.

4. Halbleiterbauelement nach einem der vorhergehenden Ansprüche, **dadurch gekennzeichnet, dass** das Halbleitersubstrat (101) Silizium ist.

5. Halbleiterbauelement nach einem der vorhergehenden Ansprüche, **dadurch gekennzeichnet, dass** oberhalb der Deckschicht (150) eine Membranschicht (140) vorgesehen ist.

6. Verfahren zur Herstellung eines Halbleiterbauelements, insbesondere nach einem der vorhergehenden Ansprüche, **dadurch gekennzeichnet, dass** eine Deckschicht (150) mit einem ersten Teilbereich (122) und einem zweiten Teilbereich (121, 125, 126) dadurch erzeugt wird, dass der zweite Teilbereich (121, 125, 126) bei der Bildung der Poren durch eine Abdeckung (110) abgedeckt wird, so dass sich die Poren unterhalb der Abdeckung (110) lateral bilden.

7. Verfahren nach Anspruch 6, **dadurch gekennzeichnet, dass** der zweite Teilbereich (121, 125, 126) eine geringe Dotierung aufweist als der erste Teilbereich (122), so dass die Poren im zweiten Teilbereich (121, 125, 126) kleiner als im ersten Teilbereich (122) sind.

8. Verfahren nach Anspruch 6 oder 7, **dadurch gekennzeichnet, dass** die Abdeckung (110) in Linien oder in Punkten bzw. kleinen Quadraten vorgesehen ist.
